# EUROPEAN PATENT APPLICATION

(11) **EP 4 557 919 A1**
(43) Date of publication of application: **21.05.2025**
(21) Application number: 24201149.2
(22) Date of filing: 18.09.2024
(51) Int. Cl.: H10K 59/121, H10K 59/38, H10K 59/80

(54) **DISPLAY APPARATUS**

(30) Priority: 20.11.2023 KR 20230161450
(71) Applicant: Samsung Display Co., Ltd., Gyeonggi-do 17113 (KR)
(72) Inventor: Park, Haechan, 17113 Yongin-si, Gyeonggi-do (KR); Ryu, Soohye, 17113 Yongin-si, Gyeonggi-do (KR); Park, Hongjo, 17113 Yongin-si, Gyeonggi-do (KR); Oh, Baekmin, 17113 Yongin-si, Gyeonggi-do (KR); Yun, Haeju, 17113 Yongin-si, Gyeonggi-do (KR); Lee, Eunggyu, 17113 Yongin-si, Gyeonggi-do (KR); Lee, Hyemin, 17113 Yongin-si, Gyeonggi-do (KR); Jang, Eunje, 17113 Yongin-si, Gyeonggi-do (KR)
(74) Representative: Gulde & Partner

(57) **Abstract**

A display apparatus of which configuration may be simple and in which reflection of external light can be effectively reduced, the display apparatus including a substrate including a component area and a main area, the component area including sub-display areas and transmission areas, the main display area at least partially surrounding the component area, main pixel electrodes located in the main display area and spaced apart from one another, sub-pixel electrodes located in the sub-display areas and spaced apart from one another, three color filter layers stacked on each other in the main display area to correspond to a space between the main pixel electrodes, and two color filter layers stacked on each other in the component area to correspond to a space between the transmission areas.

## Description

### BACKGROUND

### 1. Technical Field

One or more embodiments relate to a display apparatus with a simple configuration and capable of effectively reducing the reflection of external light.

### 2. Description of the Related Art

In general, if a display apparatus has high external light reflectance, which is a ratio at which external light is reflected from the display apparatus, the visibility of an image displayed by the display apparatus may be reduced. Thus, a configuration for reducing the external light reflectance needs to be considered.

### SUMMARY

However, in display apparatuses according to the related art, a configuration for reducing the reflectance of external light may be complicated.

One or more embodiments includes a display apparatus with a simple configuration and capable of effectively reducing the reflection of external light. However, this objective is merely illustrative, and the scope of the disclosure may not be limited thereto.

Additional aspects will be set forth in part in the description which follows and, in part, will be apparent from the description, or may be learned by practice of the presented embodiments of the disclosure.

According to one or more embodiments, a display apparatus may include a substrate including a component area and a main display area, the component area including sub-display areas and transmission areas, the main display area at least partially surrounding the component area, main pixel electrodes located in the main display area and spaced apart from one another, sub-pixel electrodes located in the sub-display areas and spaced apart from one another, three color filter layers stacked on each other in the main display area to correspond to a space between the main pixel electrodes, and two color filter layers stacked on each other in the component area to correspond to a space between the transmission areas. The display apparatus may further include a component arranged under the substrate to correspond to the component area. The transmission areas may be areas through which light and/or sound output transmitted from the component to the outside is received or in which light and/or sound proceeding toward the component from the outside is received. The transmission areas may be arranged to surround the sub-display areas.

. The component may be an electronic element using light or sound.

The display apparatus may include a display panel including the substrate and an anti-reflection layer arranged on the substrate. The anti-reflection layer may include the color filter layers.

The three color filter layers may include a blue main color filter layer through which blue light passes, a red main color filter layer through which red light passes, and a green main color filter layer through which green light passes.

The blue main color filter layer, the red main color filter layer, and the green main color filter layer may be sequentially stacked on each other in a direction away from the substrate.

In the main display area, a red sub-pixel, a green sub-pixel, and a blue sub-pixel may be included, each of the red sub-pixel, the green sub-pixel and the blue sub-pixel may comprise one of the main pixel electrodes, the blue main color filter layer may have first main openings exposing a center of a one of the main pixel electrodes corresponding to the red-sub-pixel and a center of a one of the main pixel electrodes corresponding to the green sub-pixel, the red main color filter layer may be disposed on the blue main color filter layer and may fill a one of the first main openings corresponding to the red sub-pixel, the red main color filter layer may have second main openings exposing a center of a one of the main pixel electrodes corresponding to the blue sub-pixel and the center of the one of the main pixel electrodes corresponding to the green sub-pixel, the green main color filter layer may be disposed on the red main color filter layer and may fill a one of the first main openings corresponding to the green sub-pixel and a one of the second main openings corresponding to the green sub-pixel, and the green main color filter layer may have third main openings exposing the center of the one of the main pixel electrodes corresponding to the blue sub-pixel and the center of the one of the main pixel electrodes corresponding to the red sub-pixel.

An area of a one of the third main openings corresponding to the red sub-pixel may be greater than an area of the one of the first main openings corresponding to the red sub-pixel, an area of the one of the second main openings corresponding to the green sub-pixel may be greater than an area of the one of the first main openings corresponding to the green sub-pixel, an area of a one of the third main openings corresponding to the blue sub-pixel may be greater than an area of the one of the second main openings corresponding to the blue sub-pixel.

The two color filter layers may include a blue sub-color filter layer through which blue light passes, and a red sub-color filter layer through which red light passes.

The blue sub-color filter layer and the red sub-color filter layer may be sequentially stacked on each other in a direction away from the substrate.

In the component area, a red sub-pixel, a green sub-pixel, and a blue sub-pixel may be included, each of the red sub-pixel, the green sub-pixel and the blue sub-pixel may include one of the sub-pixel electrodes, the blue sub-color filter layer may have first sub-openings exposing the transmission areas and a center of a one of the sub-pixel electrodes corresponding to the red sub-pixel and a center of a one of the sub-pixel electrodes corresponding to the green sub-pixel, and the red sub-color filter layer may be disposed on the blue sub-color filter layer and may fill a one of the first sub-openings corresponding to the red sub-pixel, the red sub-color filter layer may have second sub-openings exposing the transmission areas and a center of a one of the sub-pixel electrodes corresponding to the blue sub-pixel and the center of the one of the sub-pixel electrodes corresponding to the green sub-pixel.

The display apparatus may further include in the component area a green sub-color filter layer to fill a one of the first sub-openings corresponding to the green sub-pixel and a one of the second sub-openings corresponding to the green sub-pixel.

The green sub-color filter layer may extend to a space between the green sub-pixel and a one of the transmission areas adjacent to the green sub-pixel.

A distal end of the green sub-color filter layer in a direction to the one of the transmission areas adjacent to the green sub-pixel may be disposed on the red sub-color filter layer.

The green sub-color filter layer may be disposed on the red sub-color filter layer in the space between the green sub-pixel and the one of the transmission areas adjacent to the green sub-pixel.

The green sub-color filter layer may have an island shape in a plan view.

A width of the blue sub-color filter layer may be greater than a width of the red sub-color filter layer in an area between ones of the transmission areas.

In the transmission areas, an area of each of the second sub-openings may be greater than an area of each of the first sub-openings.

In the main display area, the three color filter layers may include a blue main color filter layer through which blue light passes, a red main color filter layer through which red light passes, and a green main color filter layer through which green light passes, a red sub-pixel, a green sub-pixel, and a blue sub-pixel may be included, each of the red sub-pixel, the green sub-pixel, and the blue sub-pixel may include one of the main pixel electrodes, the blue main color filter layer, the red main color filter layer, and the green main color filter layer may be sequentially stacked on each other in a direction away from the substrate, the blue main color filter layer may have first main openings exposing a center of a one of the main pixel electrodes corresponding to the red sub-pixel and a center of a one of the main pixel electrodes corresponding to the green sub-pixel, the red main color filter layer may be disposed on the blue main color filter layer and may fill a one of the first main openings corresponding to the red sub-pixel, the red main color filter layer may have second main openings exposing a center of a one of the main pixel electrodes corresponding to the blue sub-pixel and the center of the one of the main pixel electrodes corresponding to the green sub-pixel, the green main color filter layer may be disposed on the red main color filter layer and may fill a one of the first main openings corresponding to the green sub-pixel and a one of the second main openings corresponding to the green sub-pixel, and the green main color filter layer may have third main openings exposing the center of the one of the main pixel electrodes corresponding to the blue sub-pixel and the center of the one of the main pixel electrodes corresponding to the red sub-pixel.

The blue main color filter layer and the blue sub-color filter layer may be integral with each other as a single body, and the red main color filter layer and the red sub-color filter layer may be integral with each other as a single body.

The main display area may surround the component area.

The green main color filter layer may have a component opening corresponding to the component area.

The display apparatus may further include a plurality of green sub-color filter layers that may be located in the component opening and spaced apart from one another in a plan view.

Other aspects, features, and advantages other than those described above will be apparent from the detailed description, claims, and drawings for carrying out the disclosure below.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a plan view schematically illustrating a display apparatus according to an embodiment;
FIG. 2 is a plan view schematically illustrating a display apparatus according to an embodiment;
FIG. 3 is a cross-sectional view schematically illustrating a part of the display apparatus of FIG. 1;
FIG. 4 is a cross-sectional view schematically illustrating a part of a display apparatus according to an embodiment;
FIG. 5 is a cross-sectional view schematically illustrating a part of the display apparatus of FIG. 1;
FIG. 6 is a cross-sectional view schematically illustrating another part of the display apparatus of FIG. 1;
FIG. 7 is a plan view schematically illustrating a part of the display apparatus of FIG. 1 including the portion shown in FIG. 5;
FIGS. 8 through 10 are plan views schematically illustrating a part of the display apparatus of FIG. 1 shown in FIG. 7;
FIG. 11 is a plan view schematically illustrating a part of the display apparatus of FIG. 1 including the portion shown in FIG. 6;
FIGS. 12 through 14 are plan views schematically illustrating a part of the display apparatus of FIG. 1 shown in FIG. 11;
FIG. 15 is a plan view schematically illustrating a part of the display apparatus of FIG. 1; and
FIG. 16 is a plan view schematically illustrating a part of the display apparatus of FIG. 1.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the inventive concepts. Further, the blocks, units, and/or modules of some embodiments may be physically combined into more complex blocks, units, and/or modules without departing from the scope of the inventive concepts.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

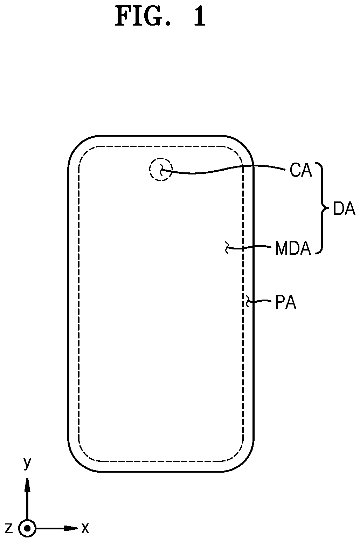

FIG. 1 is a plan view schematically illustrating a display apparatus according to an embodiment.

The display apparatus according to the embodiment may be an electronic apparatus such as a smartphone, a mobile phone, a navigation device, a game machine, a television (TV), a head portion for a vehicle, a notebook computer, a laptop computer, a tablet computer, a personal media player (PMP), and personal digital assistants (PDA). The electronic apparatus may be a flexible device.

The display apparatus may include a display area DA and a peripheral area PA outside the display area DA. When the display area DA is viewed in a plan view, the display area DA may have approximately a rectangular shape as shown in FIG. 1. Of course, the disclosure is not limited thereto, and the display area DA may have a polygonal shape such as a triangle, pentagon, hexagon, or a circular shape, an elliptical shape or an atypical shape. The corner of the display area DA may have a round shape. The peripheral area PA may be a kind of non-display area in which no display elements may be arranged. The display area DA may be entirely surrounded by the peripheral area PA.

Pixels including various display elements such as organic light-emitting diodes (OLEDs) may be arranged in the display area DA. The pixels may be arranged in various shapes, such as a stripe arrangement, a PenTile^{®} arrangement, a mosaic arrangement, and the like in the x-axis direction and the y-axis direction and may display images.

The display area DA may include a main display area MDA and a component area CA. The main display area MDA may have a shape surrounding the component area CA. However, the disclosure may not be limited thereto, and various modifications that a part of the component area CA may be in contact with the peripheral area PA may be possible. The main display area MDA may at least partially surround the component area CA.

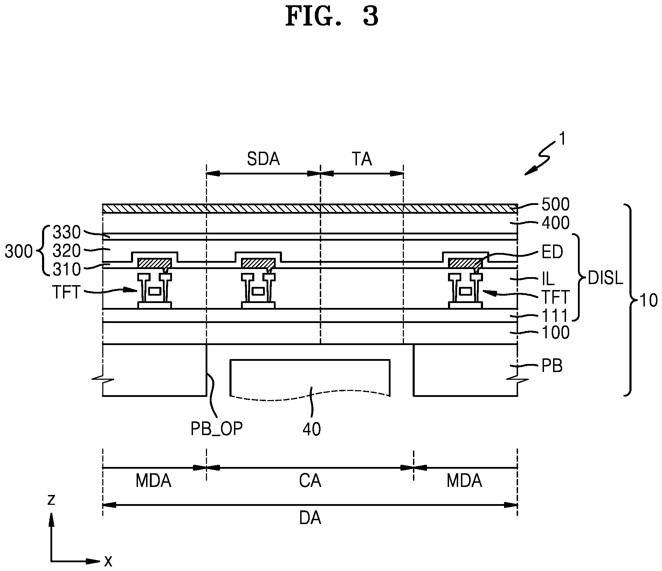

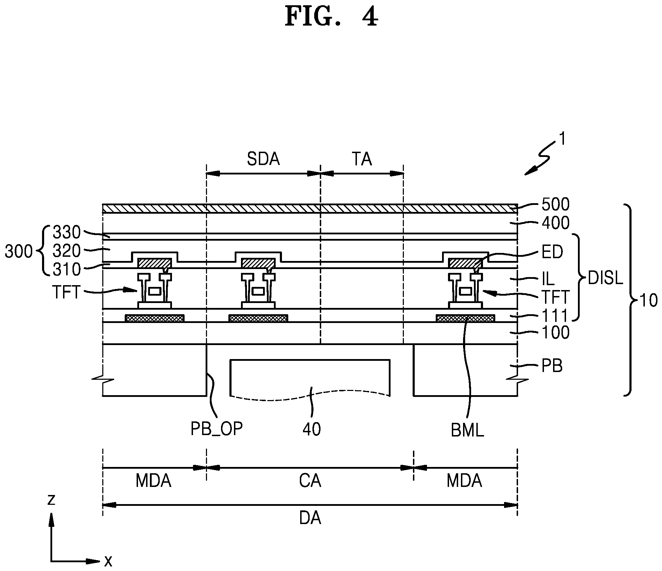

As will be described below with reference to FIGS. 3 and 4, a component (see 40 of FIGS. 3 and 4) that is an electronic element may be arranged under a display panel 10 to correspond to the component area CA. The component area CA may include a transmission area TA through which light and/or sound output is transmitted from the component 40 to the outside or in which light and/or sound proceeding toward the component 40 from the outside may be received.

The component 40 may be an electronic element using light or sound. For example, the electronic element may be a proximity sensor that measures the distance, a sensor that recognizes a part of the user's body (e.g., a fingerprint, iris, face, etc.), a small lamp that outputs light, an illumination sensor to measure brightness, or an image sensor (e.g., a camera) that captures images. The electronic element using light may use light in various wavelength bands such as visible rays, infrared rays or ultraviolet rays. The electronic element using sound may use ultrasound or sound in other frequency bands. In some embodiments, the component 40 may include sub-components such as a light-emitting portion and a light-receiving portion. The component 40 may include an integrated light-emitting portion and light-receiving portion or may include a pair of a light-emitting portion and light-receiving portion that may be physically separated from each other.

In the display apparatus according to an embodiment, in case that light transmits through the component area CA, light transmittance may be about 10% or more, about 20% or more, about 30% or more, about 40% or more, about 50% or more, about 60% or more, about 70% or more, about 75% or more, about 80% or more, about 85% or more, or about 90% or more.

When viewed in a direction (z-axis direction), which is approximately perpendicular to an upper surface of the display apparatus 1, the shape of the component area CA may be a polygonal shape such as a triangle, a rectangle, a pentagon, a hexagon, a circle, an ellipse, a star shape, or an atypical shape.

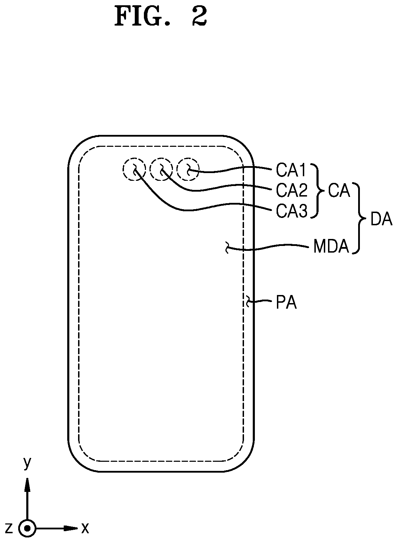

In FIG. 1, the display area DA may include a component area CA. However, the disclosure may not be limited thereto. For example, as shown in FIG. 2 that is a plan view schematically illustrating a display apparatus according to an embodiment, the component area CA may include multiple sub-component areas CA1, CA2, and CA3 that may be spaced apart from one another. Sizes of the sub-component areas CA1, CA2, and CA3 may be different from one another as occasion demands.

In case that the component area CA includes the sub-component areas CA1, CA2 and CA3, the component 40 that varies functions to correspond to each of the sub-component areas CA1, CA2, and CA3 may be arranged. For example, a camera may be arranged under the display panel 10 to correspond to a first sub-component area CA1, and an illumination sensor may be arranged under the display panel 10 to correspond to a second sub-component area CA2, and a proximity sensor may be arranged under the display panel 10 to correspond to a third sub-component area CA3.

FIG. 3 is a cross-sectional view schematically illustrating a part of the display apparatus 1 of FIG. 1. As shown in FIG. 3, the display apparatus 1 may include the display panel 10 and the component 40 arranged to overlap the display panel 10. A cover window (not shown) for protecting the display panel 10 may be arranged on the display panel 10.

The display area DA of the display panel 10 may include a component area CA and a main display area MDA. A main image may be displayed in the main display area MDA, and an auxiliary image may be displayed in the component area CA. The component 40 may be arranged under the display panel 10 to correspond to the component area CA. When viewed from a direction (z-axis direction) approximately perpendicular to the display apparatus 1 (i.e., in a plan view), the component area CA may overlap the component 40.

The display panel 10 may include a substrate 100, a display layer DISL, a touch screen layer 400, and an anti-reflection layer 500 arranged on the substrate 100, and a panel protective member PB arranged under the substrate 100.

The substrate 100 may include glass, metal, polymer resin, or a combination thereof. In case that the substrate 100 has flexible or bendable characteristics, the substrate 100 may include a polymer resin such as polyethersulfone (PES), polyacrylate, polyetherimide (PEI), polyethylene naphthalate (PEN), polyethylene terephthalate (PET), polyphenylene sulfide (PPS), polyarylate, polyimide (PI), polycarbonate (PC), cellulose acetate propionate (CAP) , or a combination thereof. Of course, various modifications may be possible, such as the substrate 100 may have a multi-layered structure including two layers including such a polymeric resin and a barrier layer between the layers, wherein the barrier layer includes an inorganic material (e.g., silicon oxide, silicon nitride, silicon oxynitride, etc.) between the layers.

The display layer DISL on the substrate 100 may include a pixel circuit including thin-film transistors (TFTs), a light-emitting element ED that is a display element, and a thin-film encapsulation layer 300. In FIG. 3, the display layer DISL may include a buffer layer 111, and the TFTs may be arranged on the buffer layer 111. The light-emitting element ED may be an organic light-emitting diode (OLED). The pixel circuit including the TFTs may control light-emitting or the degree of light-emitting of the light-emitting element ED. Of course, a semiconductor layer of the TFTs and an insulating layer IL for insulation between a gate electrode and source/drain electrodes may be included in the display layer DISL.

The light-emitting element ED may be located in the component area CA in addition to the main display area MDA. The component area CA may include sub-display areas SDA and transmission areas TA, and light-emitting elements ED may be arranged in the sub-display areas SDA. The transmission areas TA may be defined as areas in which the light-emitting elements ED may not be arranged in the component area CA. The transmission areas TA may be areas through which light/signal emitted from the component 40 disposed to correspond to the component area CA or light/signal incident onto the component 40 transmits. The TFTs electrically connected to the light-emitting elements ED located in the component area CA may be located in the component area CA as shown in FIG. 3, or may be located in the main display area MDA and may be electrically connected to the light-emitting elements ED located in the component area CA through wirings or the like.

Display elements such as the light-emitting elements ED may be covered by the thin-film encapsulation layer 300 as shown in FIG. 3. Unlike this, the display elements may also be covered by a sealing substrate. The thin-film encapsulation layer 300 may include at least one inorganic encapsulation layer and at least one organic encapsulation layer as shown in FIG. 3. For example, the thin-film encapsulation layer 300 may include a first inorganic encapsulation layer 310, a second inorganic encapsulation layer 330, and an organic encapsulation layer 320 therebetween.

The first inorganic encapsulation layer 310 and the second inorganic encapsulation layer 330 may include one or more inorganic insulating materials such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), or zinc oxide (ZnOₓ) formed through chemical vapor deposition (CVD) or the like. The organic encapsulation layer 320 may include a polymer-based material. The polymer-based material may include silicon-based resin, acryl-based resin (e.g., polymethyl methacrylate, polyacrylic acid etc.), epoxy resin, polyimide, polyethylene, the like, or a combination thereof.

Each of the first inorganic encapsulation layer 310, the organic encapsulation layer 320, and the second inorganic encapsulation layer 330 may be integral with each other to cover the main display area MDA and the component area CA.

The touch screen layer 400 may obtain coordinate information according to an external input, for example a touch event. The touch screen layer 400 may include a touch electrode and touch lines electrically connected to the touch electrode. The touch screen layer 400 may sense external input by using a self-capacitance method or mutual capacitance method.

The touch screen layer 400 may be formed on the thin-film encapsulation layer 300. The touch screen layer 400 may be arranged on the thin-film encapsulation layer 300 through an adhesive layer such as an optical clear adhesive (OCA) after being separately formed on the touch substrate. In case that the touch screen layer 400 may be formed (e.g., directly formed) on the thin-film encapsulation layer 300, the adhesive layer may not be disposed between the touch screen layer 400 and the thin-film encapsulation layer 300.

The anti-reflection layer 500 may be configured to reduce a degree at which light (external light) incident onto the display apparatus 1 from the outside is reflected from the display apparatus 1. The anti-reflection layer 500 may include color filters and may also include an overcoat layer as occasion demands. A detailed configuration of the anti-reflection layer 500 will be described below.

A cover window (not shown) may be arranged on the display panel 10, i.e., on the anti-reflection layer 500 to protect the display panel 10. The cover window may be coupled to the anti-reflection layer 500 through an adhesive layer such as an optically clear adhesive (OCA). The cover window may include a glass material or plastic material. The glass material may include ultra-thin glass. The plastic material may include polyethersulfone, polyacrylate, polyether imide, polyethylene naphthalate, polyethylene terephthalate, polyphenylene sulfide, polyarylate, polyimide, polycarbonate, cellulose acetate propionate, or a combination thereof.

The panel protective member (or panel lower cover) PB may be attached to a lower portion of the substrate 100 and may support and protect the substrate 100. The panel protective member PB may have an opening PB_OP corresponding to the component area CA. The panel protective member PB may have the opening PB_OP so that light transmittance of the component area CA may be enhanced. The panel protective member PB may include polyethylene terephthalate or polyimide.

The area of the component area CA may be greater than the area in which the component 40 is arranged. Thus, the area of the opening PB_OP provided in the panel protective member PB may not coincide with the area of the component area CA. In FIG. 3, at least a part of the component 40 is inserted into the opening PB_OP provided in the panel protective member PB. However, the component 40 may be spaced apart from the display panel 10.

As shown in FIG. 4 that is a cross-sectional view schematically illustrating a part of the display apparatus 1 according to an embodiment, the display panel 10 may further include a bottom metal layer BML. In FIG. 4, the bottom metal layer BML may be between the substrate 100 and the buffer layer 111. The bottom metal layer BML may be arranged to overlap pixel circuits to protect the pixel circuits. In FIG. 4, the bottom metal layer BML may be located under the thin-film transistor TFT. However, the disclosure may not be limited thereto. The bottom metal layer BML may be located under the pixel circuits including the thin-film transistors TFTs.

The bottom metal layer BML may prevent or reduce effects on the pixel circuits when light reaches the pixel circuits. The bottom metal layer BML may be located only in the sub-display area SDA of the component area CA and may also be located in the main display area MDA. The bottom metal layer BML in the component area CA may have an opening BML_OP corresponding to the transmission area TA. Also, the pixel defining layer 123 may have a third through hole (or opening) 123OP3 corresponding to the transmission area TA, and the second electrode (or common electrode) 230 may have an opening 230OP corresponding to the transmission area TA.

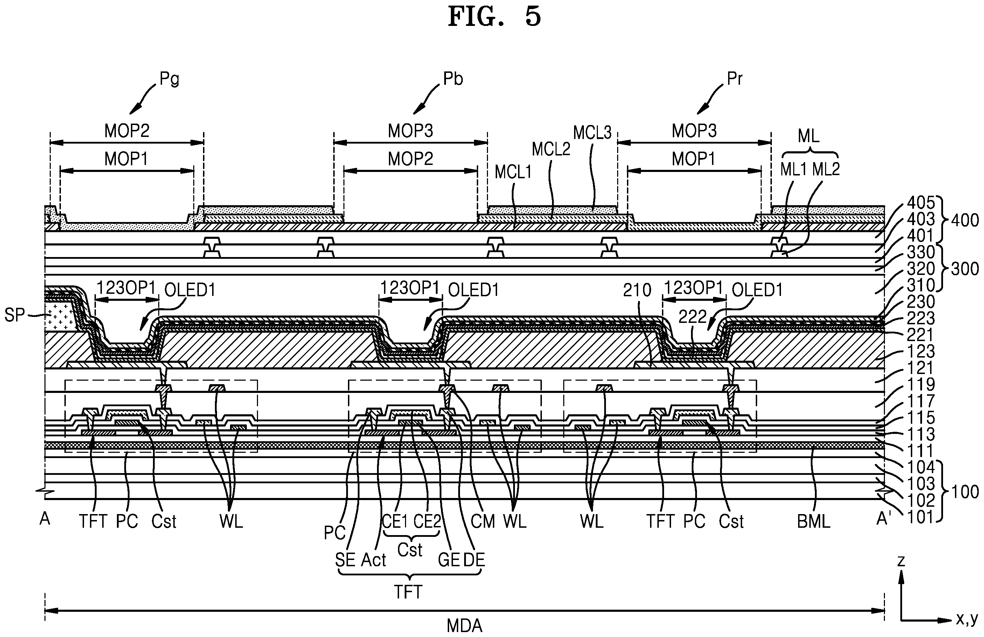

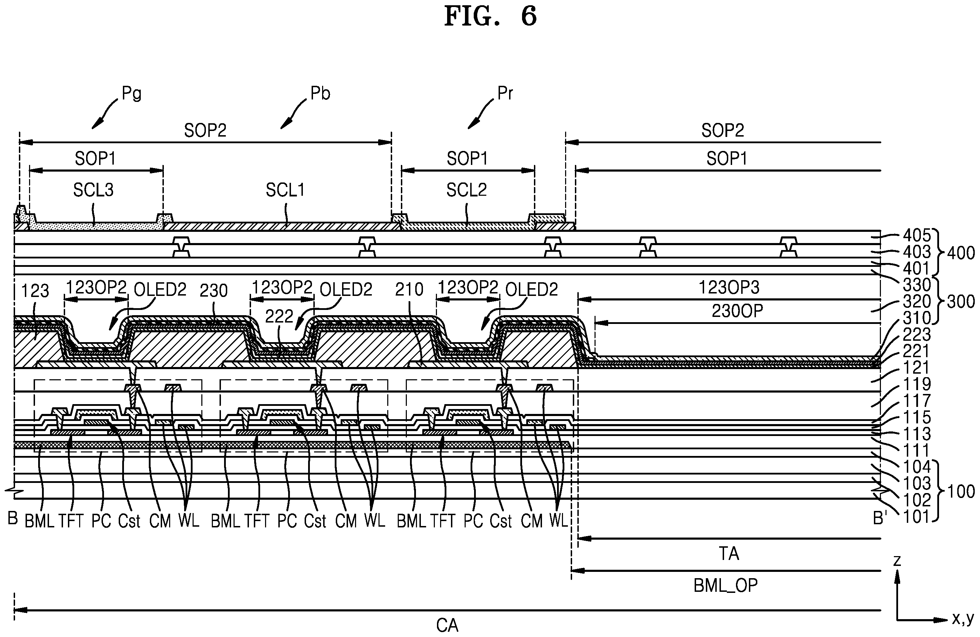

FIG. 5 is a cross-sectional view schematically illustrating a part of the display apparatus 1 of FIG. 1, and FIG. 6 is a cross-sectional view schematically illustrating another part of the display apparatus 1 of FIG. 1. Specifically, FIG. 5 is a cross-sectional view schematically illustrating a part of the main display area MDA of the display apparatus 1 of FIG. 1, and FIG. 6 is a cross-sectional view schematically illustrating a part of the component area CA of the display apparatus 1 of FIG. 1. FIGS. 5 and 6 illustrate that a light-emitting element as a display element may be an organic light-emitting diode. An organic light-emitting diode may be arranged in each of the main display area MDA and the component area CA. For convenience of explanation, an organic light-emitting diode arranged in the main display area MDA may be referred to as a first organic light-emitting diode OLED1, and an organic light-emitting diode arranged in the component area CA may be referred to as a second organic light-emitting diode OLED2.

Referring to FIGS. 5 and 6, the first organic light-emitting diode OLED1 and the second organic light-emitting diode OLED2 may be arranged on the substrate 100.

The substrate 100 may include a first base layer 101, a first barrier layer 102, a second base layer 103, and a second barrier layer 104. The first base layer 101 and the second base layer 103 may include polymer resin, and each of the first barrier layer 102 and the second barrier layer 104 may include an inorganic insulating material. The polymer resin may include polyethersulfone, polyacrylate, polyether imide, polyethylene naphthalate, polyethylene terephthalate, polyphenylene sulfide, polyarylate, polyimide, polycarbonate, cellulose acetate propionate, or a combination thereof. The inorganic insulating material may include silicon oxide, silicon nitride and/or silicon oxynitride, the like, or a combination thereof. Of course, the layer structure of the substrate 100 may be modified, and the substrate 100 may have a single layer structure including glass or metal.

A buffer layer 111 may be arranged on the substrate 100. The buffer layer 111 may prevent or minimize penetration of foreign material, moisture or external air from a lower portion of the substrate 100. The buffer layer 111 may include an inorganic insulating material such as silicon oxide, silicon oxynitride, silicon nitride, or a combination thereof, and may have a single layer or multi-layered structure including the above-described materials.

The bottom metal layer BML may be between the substrate 100 and the buffer layer 111 and may be located in the main display area MDA and the component area CA. The bottom metal layer BML may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu). The bottom metal layer BML may be arranged to correspond to at least a part of the pixel circuit PC. For example, the bottom metal layer BML may have a structure in which at least areas corresponding to driving transistors may be electrically connected to each other, and the bottom metal layer BML may have openings corresponding to the other circuit elements. Of course, the bottom metal layer BML may be arranged only in the component area CA and may be omitted from the main display area MDA and the component area CA.

Each of the first organic light-emitting diode OLED1 and the second organic light-emitting diode OLED2 may be electrically connected to the corresponding pixel circuit PC. The first organic light-emitting diode OLED1 may be electrically connected to the pixel circuit PC between the substrate 100 and the first organic light-emitting diode OLED1, and the second organic light-emitting diode OLED2 may be electrically connected to the pixel circuit PC between the substrate 100 and the second organic light-emitting diode OLED2.

The pixel circuit PC may include a thin-film transistor TFT and a capacitor Cst and may be defined to include multiple wirings WL electrically connected to the thin-film transistor TFT and the capacitor Cst as occasion demands. The thin-film transistor TFT may include a semiconductor layer Act, a gate electrode GE overlapping a channel region of the semiconductor layer Act, a source electrode SE electrically connected to a source region of the semiconductor layer Act, and a drain electrode DE electrically connected to a drain region of the semiconductor layer Act. Here, the source electrode SE and the drain electrode DE may be portions of wirings and may be defined as parts contacting the semiconductor layer Act. Also, in case that the semiconductor layer Act of a thin-film transistor TFT and the semiconductor layer Act of another thin-film transistor TFT may be electrically connected (e.g., may be directly electrically connected) to each other, the source electrode SE and/or the drain electrode DE may not be in the thin-film transistors TFTs.

A first gate insulating layer 113 may be disposed between the semiconductor layer Act and the gate electrode GE, and a second gate insulating layer 115 and/or a first interlayer insulating layer 117 may be disposed between the gate electrode GE and the source electrode SE and between the gate electrode GE and the drain electrode DE. A second interlayer insulating layer 119 may be arranged above the source electrode SE and the drain electrode DE.

The semiconductor layer Act may include polysilicon. In some embodiments, the semiconductor layer Act may include amorphous silicon. In some embodiments, the semiconductor layer Act may include oxide of at least a material selected from the group consisting of indium (In), gallium (Ga), tin (Sn), zirconium (Zr), vanadium (V), hafnium (Hf), cadmium (Cd), germanium (Ge), chromium (Cr), titanium (Ti), zinc (Zn), and a combination thereof. The semiconductor layer Act may include a channel region, and a source region and a drain region doped with impurities.

The capacitor Cst may be arranged to overlap the thin-film transistor TFT. The capacitor Cst may include a lower electrode CE1 and an upper electrode CE2 that overlap each other. As occasion demands, the gate electrode GE of the thin-film transistor TFT and the lower electrode CE1 of the capacitor Cst may be integral with each other as a single body.

The gate electrode GE or the lower electrode CE1 may include low resistance conductive materials such as molybdenum (Mo), aluminum (Al), copper (Cu) and/or titanium (Ti), and may have a single layer structure or multi-layered structure including these materials. For example, the gate electrode GE or the lower electrode CE1 may have a three-layer structure of Mo/AI/Mo.

The upper electrode CE2 may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu), and may have a single layer or multi-layered structure including the materials described above. For example, the upper electrode CE2 may have a three-layer structure of Ti/AI/Ti. A second gate insulating layer 115 may be arranged between the lower electrode CE1 and the upper electrode CE2.

The source electrode SE and/or the drain electrode DE may include Al, Pt, Pd, Ag, Mg, Au, Ni, neodymium (Nd), Ir, Cr, Li, Ca, Mo, Ti, W, and/or Cu, and may have a single layer or multi-layered structure including the materials described above. For example, the source electrode SE and/or the drain electrode DE may have a three-layer structure of Ti/AI/Ti. For your reference, the above-described first interlayer insulating layer 117 may cover the upper electrode CE2 of the capacitor Cst, and the source electrode SE and/or the drain electrode DE may be located on the first interlayer insulating layer 117.

Each of the first gate insulating layer 113, the second gate insulating layer 115, the first interlayer insulating layer 117, and the second interlayer insulating layer 119 may include an inorganic insulating material such as silicon oxide, silicon nitride, silicon oxynitride, or a combination thereof, and may have a single layer structure or multi-layered structure including these materials.

A planarization layer 121 may be arranged on the second interlayer insulating layer 119. The planarization layer 121 may include an organic material such as acryl, benzocyclobutene (BCB), polyimide, hexamethyldisiloxane (HMDSO), or a combination thereof. The planarization layer 121 may include an inorganic material. The planarization layer 121 may serve as a protective layer for covering the thin-film transistor TFT, and an upper portion of the planarization layer 121 may be approximately flat. The planarization layer 121 may have a single layer structure or multi-layered structure.

Multiple wirings WL may be arranged between the first gate insulating layer 113, the second gate insulating layer 115, the first interlayer insulating layer 117, the second interlayer insulating layer 119 and/or the planarization layer 121. The wirings WL may include data lines, scan lines or light-emitting control lines electrically connected to the thin-film transistor TFT and/or the capacitor Cst.

A connection electrode CM may be arranged above the second interlayer insulating layer 119. The thin-film transistor TFT may be electrically connected to the first electrode 210 of the corresponding organic light-emitting diode through the connection electrode CM. The connection electrode CM may be electrically connected to the thin-film transistor TFT through a contact hole in the second interlayer insulating layer 119, and the first electrode 210 may be electrically connected to the connection electrode CM through a contact hole in the planarization layer 121.

Each of the first organic light-emitting diode OLED1 and the second organic light-emitting diode OLED2 may include an overlapping structure of the first electrode 210 as a pixel electrode, a light-emitting layer 222, and a second electrode 230 as an opposite electrode. The overlapping structure may include a first functional layer 221 between the first electrode 210 and the light-emitting layer 222 and/or a second functional layer 223 between the light-emitting layer 222 and the second electrode 230. The first electrode 210 defined as a pixel electrode of the first organic light-emitting diode OLED1 located in the main display area MDA may be referred to as a main pixel electrode, and the first electrode 210 defined as a pixel electrode of the second organic light-emitting diode OLED2 located in the sub-display area SDA of the component area CA may be referred to as a sub-pixel electrode. Main pixel electrodes may be arranged in the main display area MDA to be spaced apart from one another, and sub-pixel electrodes may be arranged in the sub-display areas SDA to be spaced apart from one another.

The first electrode 210 may be located on the planarization layer 121. The first electrode 210 may include a reflective layer including Ag, Mg, Al, Pt, Pd, Au, Ni, Nd, Ir, Cr, a compound thereof, or a combination thereof. The first electrode 210 may include a reflective layer including these materials and a transparent conductive layer on and/or under the reflective layer. The transparent conductive layer may include a conductive oxide such as indium tin oxide (ITO), indium zinc oxide (IZO), zinc oxide (ZnO), indium oxide (In₂O₃), indium gallium oxide (IGO), aluminum zinc oxide (AZO), or a combination thereof. In an embodiment, the first electrode 210 may have a stack structure of ITO/Ag/ITO.

**A** pixel-defining layer 123 for covering edges of the first electrode 210 may include an opening that overlaps the center of the first electrode 210. FIGS. 5 and 6 illustrate that the pixel-defining layer 123 has a through hole (hereinafter referred to as a first through hole) 123OP1 that overlaps the first electrode 210 of the first organic light-emitting diode OLED1 and a through hole (hereinafter referred to as a second through hole) 123OP2 that overlaps the first electrode 210 of the second organic light-emitting diode OLED2.

The first through hole 123OP1 and the second through hole 123OP2 of the pixel-defining layer 123 may define a light-emitting region of the first organic light-emitting diode OLED1 and a light-emitting region of the second organic light-emitting diode OLED2, respectively. For example, a width of the first through hole 123OP1 of the pixel-defining layer 123 may correspond to a width of the light-emitting region of the first organic light-emitting diode OLED1, and a width of the second through hole 123OP2 of the pixel-defining layer 123 may correspond to a width of the light-emitting region of the second organic light-emitting diode OLED2.

The pixel-defining layer 123 may include a light-shielding insulating material. Thus, the pixel-defining layer 123 may be a light-shielding insulating layer that may be colored and opaque, and may be seen as black for example. For example, the pixel-defining layer 123 may include a polyimide (Pl)-based binder and a pigment in which red, green and blue colors may be mixed with each other. The pixel-defining layer 123 may include a cardo-based binder resin and a mixture of a lactam black pigment and a blue pigment. The pixel-defining layer 123 may include carbon black. The pixel-defining layer 123 may prevent reflection of external light together with the anti-reflection layer 500 to be described later, and may improve contrast of a display panel.

As occasion demands, spacers SP may be arranged on the pixel-defining layer 123. The spacers SP may include a different material from the pixel-defining layer 123. For example, the pixel-defining layer 123 may include negative photosensitive materials, while the spacers SP may include different materials such as positive photosensitive materials, and may be formed through a separate mask process. The spacers SP may be transparent insulating layers.

The light-emitting layer 222 may be located to correspond to each of the first through hole 123OP1 and the second through hole 123OP2 of the pixel-defining layer 123 and may overlap the first electrode 210. The light-emitting layer 222 may include a polymer organic material or a low molecular weight organic material that emits light of a certain color corresponding to each pixel (sub-pixel). A first functional layer 221 and a second functional layer 223 may be located under and on the light-emitting layer 222, respectively.

The first functional layer 221 may include for example a hole transport layer (HTL) or a HTL and a hole injection layer (HIL). The second functional layer 223 may include an electron transport layer (ETL) and/or an electron injection layer (EIL). Unlike the light emitting layer 222, the first functional layer 221 and/or the second functional layer 223 may be integral with each other in several pixels. The first functional layer 221 and/or the second functional layer 223 may be integral with each other in the main display area MDA and the component area CA.

The thin-film encapsulation layer 300 may be configured to cover the first organic light-emitting diode OLED1 and the second organic light-emitting diode OLED2. The thin-film encapsulation layer 300 may include a first inorganic encapsulation layer 310, a second inorganic encapsulation layer 330, and an organic encapsulation layer 320 disposed therebetween.

Each of the first inorganic encapsulation layer 310 and the second inorganic encapsulation layer 330 may include one or more inorganic insulating materials. The inorganic insulating material may include aluminum oxide, titanium oxide, tantalum oxide, hafnium oxide, zinc oxide, silicon oxide, silicon nitride and/or silicon oxynitride.

The organic encapsulation layer 320 may include a polymer-based material. The polymer-based material may include an acryl-based resin, an epoxy-based resin, polyimide, polyethylene, the like, or a combination thereof. For example, the organic encapsulation layer 320 may include an acrylic resin, such as polymethylmethacrylate, polyacrylic acid, and the like. The organic encapsulation layer 320 may be formed by hardening a monomer or by coating a polymer.

A touch screen layer 400 may include a touch electrode, and the touch electrode may include a conductive layer ML. The touch electrode may include the conductive layer ML having a mesh structure that surrounds light-emitting regions of the first organic light-emitting diode OLED1 and the second organic light-emitting diode OLED2 in a plan view. The conductive layer ML may include a connection structure of the first conductive layer ML1 and the second conductive layer ML2 as shown in FIGS. 5 and 6. In embodiment, the conductive layer ML may include one of the first conductive layer ML1 and the second conductive layer ML2. The conductive layer ML may include Mo, Mb, Ag, Ti, Cu, Al, an alloy thereof, or a combination thereof.

The touch screen layer 400 may include a first touch insulating layer 401 on the thin-film encapsulation layer 300, a second touch insulating layer 403 on the first touch insulating layer 401, and a third touch insulating layer 405 on the second touch insulating layer 403. The first conductive layer ML1 may be between the first touch insulating layer 401 and the second touch insulating layer 403, and the second conductive layer ML2 may be between the second touch insulating layer 403 and the third touch insulating layer 405.

The first touch insulating layer 401 through third touch insulating layers 405 may include an inorganic insulating material and/or an organic insulating material. For example, the first touch insulating layer 401 and the second touch insulating layer 403 may include an inorganic insulating material, and the third touch insulating layer 405 may include an organic insulating material.

The anti-reflection layer (see 500 of FIGS. 3 and 4) may include color filter layers. As shown in FIG. 5, three color filter layers may be stacked on each other in the main display area MDA to correspond to a space between the first electrodes 210 which may be defined as main pixel electrodes. As shown in FIG. 6, two color filter layers may be stacked on each other in the component area CA to correspond to a space between transmission areas TA. A stack structure of the color filter layers in the space between the transmission areas TA in the component area CA will be described later, and a stack structure of the color filter layers in the main display area MDA will be described.

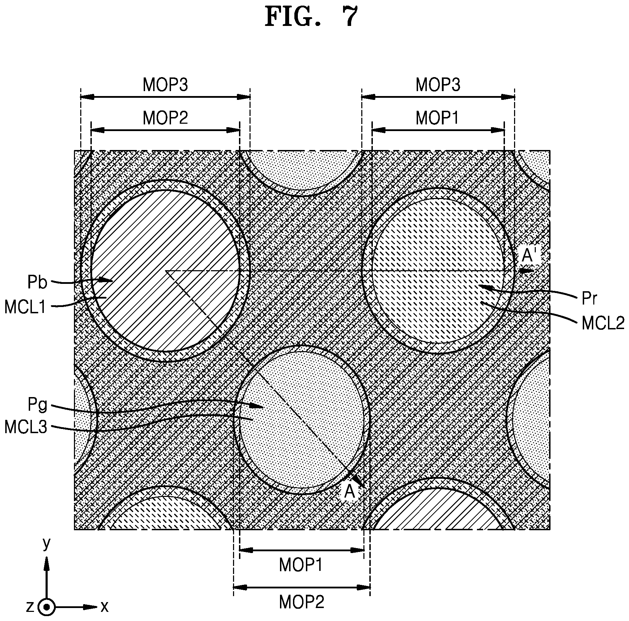

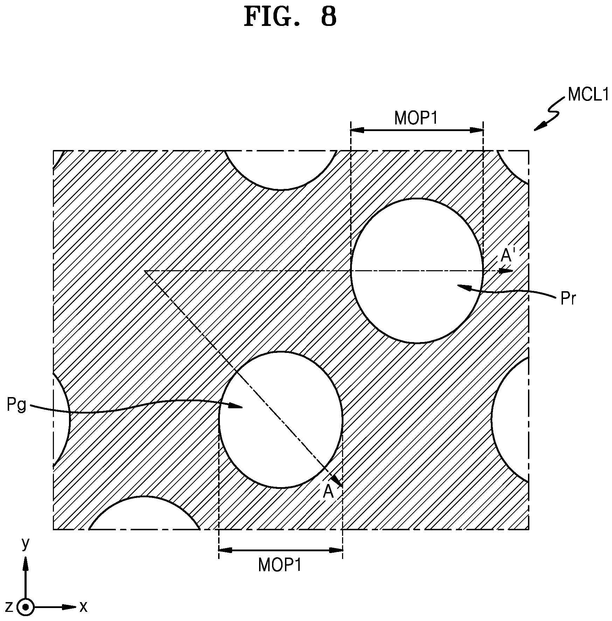

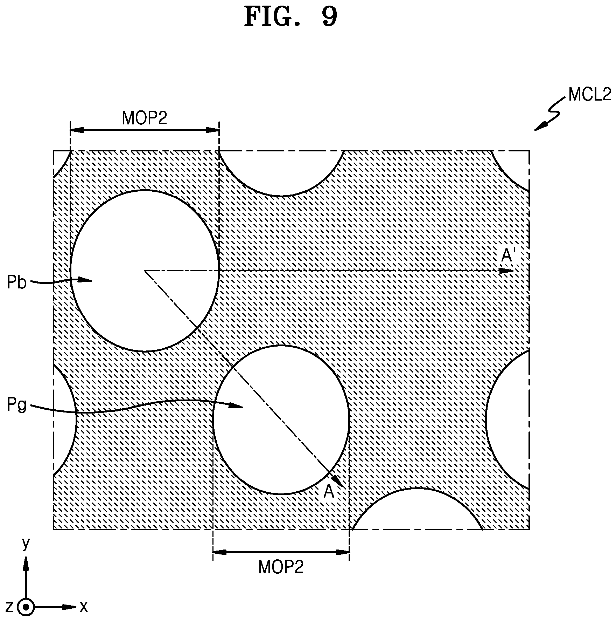

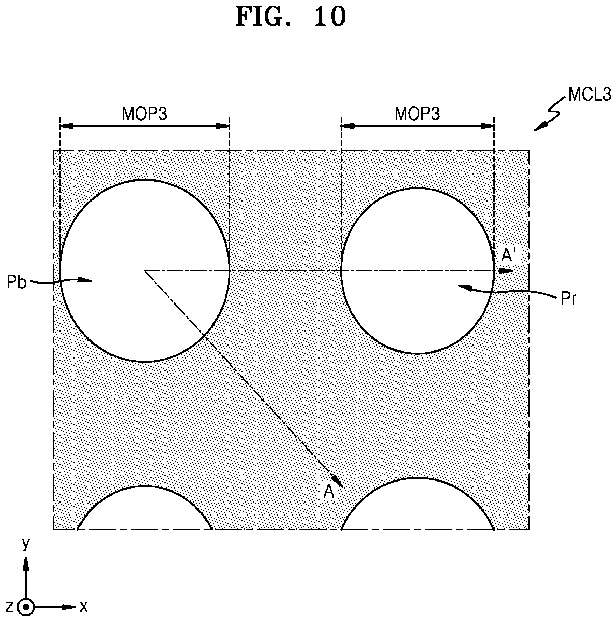

FIG. 7 is a plan view schematically illustrating main color filter layers in the main display area MDA of the display apparatus of FIG. 1 including the portion shown in FIG. 5, and FIGS. 8 through 10 are plan views schematically illustrating each of the main color filter layers shown in FIG. 7. It will be understood that FIG. 5 is a schematic cross-sectional view of the display apparatus taken along line A-A' of FIGS. 7 through 10.

Three color filter layers stacked on each other in the main display area MDA to correspond to the space between the first electrodes 210 (or main pixel electrodes) may include a blue main color filter layer MCL1 through which blue light passes, a red main color filter layer MCL2 through which red light passes, and a green main color filter layer MCL3 through which green light passes. The color filter layers may be stacked on each other in the order of the blue main color filter layer MCL1, the red main color filter layer MCL2, and the green main color filter layer MCL3 in a direction (+z direction) away from the substrate 100. Each of the red sub-pixel Pr, the green sub-pixel Pg, and the blue sub-pixel Pb may include one of the first electrodes 210 (or main pixel electrodes).

As shown in FIGS. 5, 7, and 8, the blue main color filter layer MCL1 may have first main openings MOP1 for exposing the center of each of the main pixel electrode corresponding to a red sub-pixel Pr and the main pixel electrode corresponding to a green sub-pixel Pg. The blue main color filter layer MCL1 may transmit most of blue light and may block most of red light and green light. Thus, the blue main color filter layer MCL1 may have the first main openings MOP1 for exposing the center of the main pixel electrode corresponding to the red sub-pixel Pr and the main pixel electrode corresponding to the green sub-pixel Pg, so that red light and green light emitted from the red sub-pixel Pr and the green sub-pixel Pg, respectively to the outside may not be blocked. Of course, the blue main color filter layer MCL1 may overlap the center of the main pixel electrode corresponding to the blue sub-pixel Pb, and the majority of blue light emitted from the blue sub-pixel Pb may pass through the blue main color filter layer MCL1 and may be emitted to the outside.

The red main color filter layer MCL2 may be disposed on the blue main color filter layer MCL1 and may fill a first main opening corresponding to the red sub-pixel Pr among the first main openings MOP1 of the blue main color filter layer MCL1. Furthermore, the red main color filter layer MCL2 may have second main openings MOP2 for exposing the center of each of the main pixel electrode corresponding to the blue sub-pixel Pb and the main pixel electrode corresponding to the green sub-pixel Pg. The red main color filter layer MCL2 may transmit most of red light and may block most of blue light and green light. Thus, the red main color filter layer MCL2 may have the second main openings MOP2 for exposing the center of each of the main pixel electrode corresponding to the blue sub-pixel Pb and the main pixel electrode corresponding to the green sub-pixel Pg, so that blue light and green light emitted from the blue sub-pixel Pb and the green sub-pixel Pg, respectively to the outside may not be blocked. Of course, the red main color filter layer MCL2 may overlap the center of the main pixel electrode corresponding to the red sub-pixel Pr, and a majority of red light emitted from the red sub-pixel Pr to the outside may pass through the red main color filter layer MCL2 and may be emitted to the outside.

The green main color filter layer MCL3 may be disposed on the red main color filter layer MCL2 and fill a first main opening corresponding to the green sub-pixel Pg among the first main openings MOP1 of the blue main color filter layer MCL1 and a second main opening corresponding to the green sub-pixel Pg among the second main openings MOP2 of the red main color filter layer MCL2. Furthermore, the green main color filter layer MCL3 may have third main openings MOP3 for exposing the center of each of the main pixel electrode corresponding to the blue sub-pixel Pb and the main pixel electrode corresponding to the red sub-pixel Pr. The green main color filter layer MCL3 may transmit most of green light and may block most of blue light and red light. Thus, the green main color filter layer MCL3 may have the third main openings MOP3 for exposing the center of each of the main pixel electrode corresponding to each of the blue sub-pixel Pb and the red sub-pixel Pr, so that blue light and red light emitted from the blue sub-pixel Pb and the red sub-pixel Pr, respectively to the outside may not be blocked. Of course, the green main color filter layer MCL3 may overlap the center of the main pixel electrode corresponding to the green sub-pixel Pg, but most of green light emitted from the green sub-pixel Pg to the outside may pass through the green main color filter layer MCL3 and may be emitted to the outside.

In the display apparatus according to the embodiment, the anti-reflection layer 500 may have a structure in which the blue main color filter layer MCL1, the red main color filter layer MCL2 and the green main color filter layer MCL3 may be sequentially stacked on each other in a portion corresponding to the space between the first electrodes 210, which may be defined as the main pixel electrodes in the main display area MDA. Thus, light may be blocked in the portion corresponding to the space between the first electrodes 210 without including a black matrix. Thus, contrast of images implemented by the display apparatus may be increased. Furthermore, in the case of external light, for example, in the case of external light incident on the green main color filter layer MCL3, most of the red light and blue light may be shielded, and only a part of the green light enters into the display apparatus, may be reflected by the first electrode 210, and then passes again through the green main color filter layer MCL3 to the outside. Thus, the amount of light reflected after being incident onto the display apparatus may be reduced to approximately one-third of the incident light, which may dramatically reduce the reflection of external light.

As shown in FIG. 5, in the red sub-pixel Pr, the area of the third main opening MOP3 of the green main color filter layer MCL3 may be greater than the area of the first main opening MOP1 of the blue main color filter layer MCL1. In the red sub-pixel Pr, the first main opening MOP1 of the blue main color filter layer MCL1 may define a region of the red sub-pixel Pr. Similarly, in the green sub-pixel Pg, the area of the second main opening MOP2 of the red main color filter layer MCL2 may be greater than the area of the first main opening MOP1 of the blue main color filter layer MCL1. In the green sub-pixel Pg, the first main opening MOP1 of the blue main color filter layer MCL1 may define a region of the green sub-pixel Pg. In the blue sub-pixel Pb, the area of the third main opening MOP3 of the green main color filter layer MCL3 may be greater than the area of the second main opening MOP2 of the red main color filter layer MCL2. In the blue sub-pixel Pb, the second main opening MOP2 of the red main color filter layer MCL2 may define a region of the blue sub-pixel Pb.

As occasion demands, an overcoat layer including an organic material such as polyimide or the like may be located on the anti-reflection layer 500 including the color filter layers. As described above, a cover window (not shown) may be arranged on the anti-reflection layer 500, and the cover window may be coupled to the anti-reflection layer 500 through an adhesive layer such as an optically clear adhesive (OCA).

In a flexible display apparatus, ultra-thin glass or the like may be used as a cover window and the cover window may be very thin. Thus, a protective layer including polymer resin may be located on the cover window. In case that an image of white color may be displayed in the main display area MDA, color coordinates may be slightly moved from white light to blue light due to the protective layer so that a viewer may recognize an image of bluish white color. However, in the display apparatus according to the embodiment, a green main color filter layer MCL3 among color filter layers of the anti-reflection layer 500 may be located at an uppermost portion of the main display area MDA. Thus, the green main color filter layer MCL3 has the effect of compensating color coordinate changes due to the protective layer and thus, in case that an image of white color is displayed in the main display area MDA, the viewer may recognize an image of white color as it is.

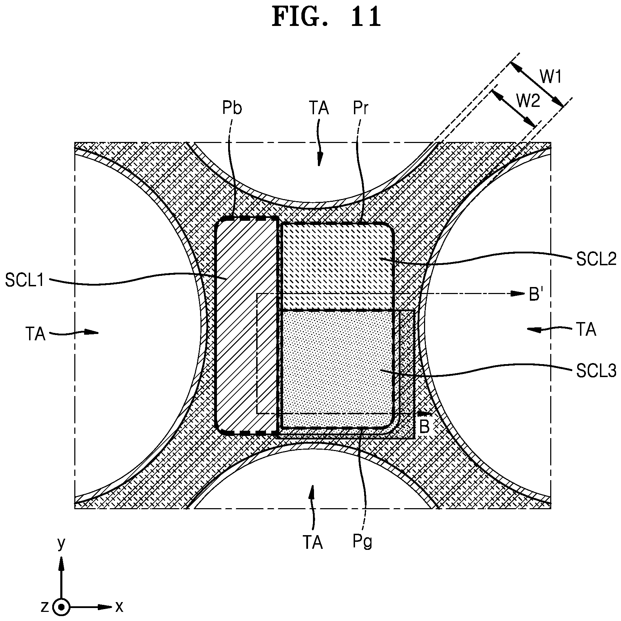

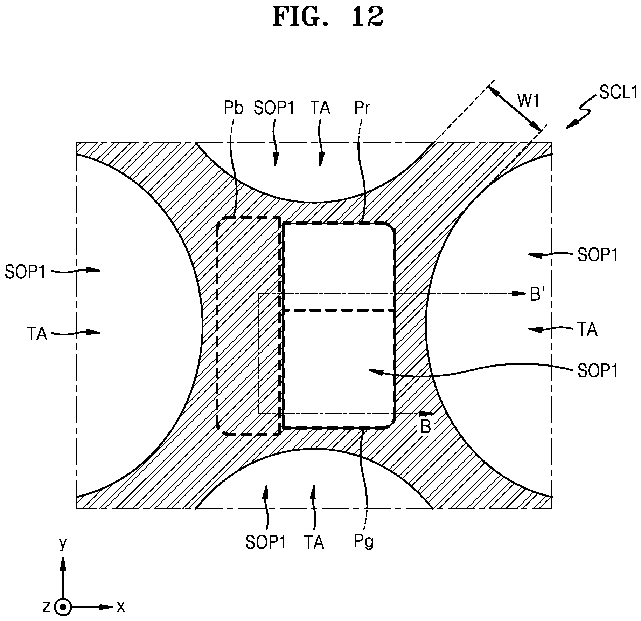

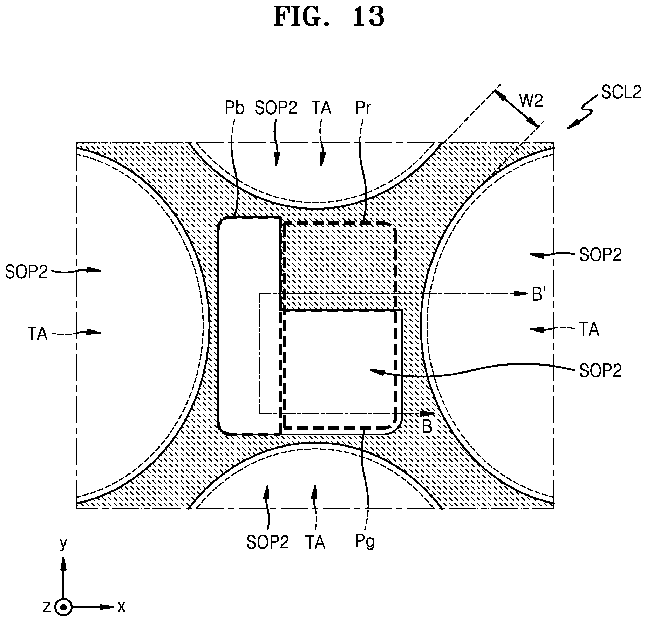

FIG. 11 is a plan view schematically illustrating sub-color filter layers in the component area CA of the display apparatus of FIG. 1 including the portion shown in FIG. 6, and FIGS. 12 through 14 are plan views schematically illustrating each of the sub-color filter layers shown in FIG. 11. It will be understood that FIG. 6 is a schematic cross-sectional view of the display apparatus taken along line B-B' of FIGS. 11 through 14.

As shown in FIGS. 11 through 14, a structure in which two color filter layers may be stacked on each other may correspond to the space between the transmission areas TA in the component area CA. Two color filter layers stacked on each other to correspond to the space between the transmission areas TA in the component area CA may include a blue sub-color filter layer SCL1 through which blue light passes, and a red sub-color filter layer SCL2 through which red light passes. The color filter layers may be stacked on each other in the order of the blue sub-color filter layer SCL1 and the red sub-color filter layer SCL2 in a direction (+z direction) away from the substrate 100. Each of the red sub-pixel Pr, the green sub-pixel Pg, and the blue sub-pixel Pb may include one of the first electrodes 210 (or main pixel electrodes).

As shown in FIGS. 6, 11, and 12, the blue sub-color filter layer SCL1 may have first sub-openings SOP1 for exposing the transmission areas TA and the center of each of the sub-pixel electrode corresponding to the red sub-pixel Pr and the sub-pixel electrode corresponding to the green sub-pixel Pg. The blue sub-color filter layer SCL1 may pass through a majority of blue light and may block most of red light and green light. Thus, the blue sub-color filter layer SCL1 may have the first sub-openings SOP1 for exposing the center of the sub-pixel electrode corresponding to the red sub-pixel Pr and the center of the sub-pixel electrode corresponding to the green sub-pixel Pg, so that red light or green light emitted from the red sub-pixel Pr and the green sub-pixel Pg, respectively to the outside may not be blocked. Of course, the blue sub-color filter layer SCL1 may overlap the center of the sub-pixel electrode corresponding to the blue sub-pixel Pb, and a majority of blue light emitted from the blue sub-pixel Pb to the outside may pass through the blue sub-color filter layer SCL1 and may be emitted to the outside. Also, the blue sub-color filter layer SCL1 may have the first sub-openings SOP1 corresponding to the transmission areas TA so that light may not be shielded in the transmission areas TA.

The red sub-color filter layer SCL2 may be disposed on the blue sub-color filter layer SCL1 and fill the first sub-opening corresponding to the red sub-pixel Pr among the first sub-openings SOP1 of the blue sub-color filter layer SCL1. Furthermore, the red sub-color filter layer SCL2 may have second sub-openings SOP2 for exposing the transmission areas TA and the center of the sub-pixel electrode corresponding to the blue sub-pixel Pb and the center of the sub-pixel electrode corresponding to the green sub-pixel Pg. The red sub-color filter layer SCL2 may transmit a majority of red light and may block a majority of blue light and green light. Thus, the red sub-color filter layer SCL2 may have the second sub-openings SOP2 for exposing the center of the sub-pixel electrodes corresponding to the blue sub-pixel Pb and the center of the sub-pixel electrodes corresponding to the green sub-pixel Pg, so that blue light and green light emitted from the blue sub-pixel Pb and the green sub-pixel Pg, respectively to the outside may not be blocked. Of course, the red sub-color filter layer SCL2 may overlap the center of the sub-pixel electrode corresponding to the red sub-pixel Pr, and most of red light emitted from the red sub-pixel Pr may pass through the red sub-color filter layer SCL2 and may be emitted to the outside. Also, the red sub-color filter layer SCL2 may have the second sub-openings SOP2 corresponding to the transmission areas TA so that light may not be shielded in the transmission areas TA.

The display apparatus according to the embodiment may include green sub-color filter layers SCL3 arranged in the component area CA, as shown in FIGS. 6, 11, and 14. The green sub-color filter layers SCL3 may fill the first sub-opening corresponding to the green sub-pixel Pg among the first sub-openings SOP1 of the blue sub-color filter layer SCL1 and may fill the second sub-opening corresponding to the green sub-pixel Pg among the second sub-openings SOP2 of the red sub-color filter layer SCL2.

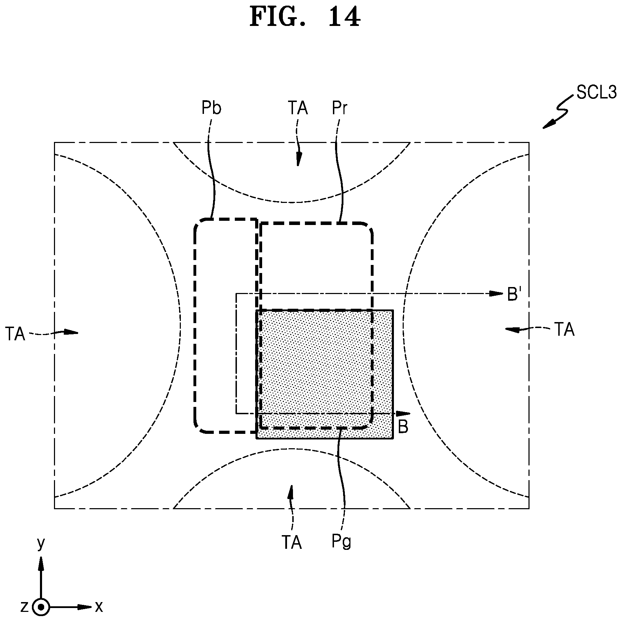

Of course, as shown in FIGS. 6 and 14, the green sub-color filter layer SCL3 may extend to the space between the green sub-pixel Pg and a transmission area adjacent to the green sub-pixel Pg among the transmission areas TA. This is to prevent the situation where the green sub-color filter layer SCL3 does not fill all portions corresponding to the green sub-pixel Pg due to a tolerance during manufacturing process. As can be seen in the vicinity of the green sub-pixel Pg of FIG. 6, the distal end of the green sub-color filter layer SCL3 in a direction of the transmission area adjacent to the green sub-pixel Pg among the transmission areas TA may be located on the red sub-color filter layer SCL2. In other words, green sub-color filter layer SCL3 may be disposed on the red sub-color filter layer SCL2 in the space between the green sub-pixel Pg and the transmission area adjacent to the green sub-pixel Pg among the transmission areas TA.

As shown in FIGS. 11, 12, and 13, the blue sub-color filter layer SCL1 may have the first sub-openings SOP1 and the red sub-color filter layer SCL2 may have the second sub-openings SOP2. In the component area CA, each of the blue sub-color filter layer SCL1 and the red sub-color filter layer SCL2 may have an integrally-formed shape. In contrast, each of the green sub-color filter layers SCL3 in the component area CA may have an island shape as shown in FIGS. 11 and 14 when viewed in a direction (z-axis direction) perpendicular to the substrate 100 (i.e., in a plan view).

In the display apparatus according to the embodiment, the anti-reflection layer 500 may have a structure in which the blue sub-color filter layer SCL1 and the red sub-color filter layer SCL2 may be sequentially stacked on each other in a portion corresponding to the space between the transmission areas TA in the component area CA. Thus, light may be blocked in a portion corresponding to the space between the transmission areas TA without including a black matrix. In other words, the blue sub-color filter layer SCL1 may allow only blue light to pass, and the red sub-color filter layer SCL2 may allow only red light to pass, so that most of visible rays may be shielded in a portion where the blue sub-color filter layer SCL1 and the red sub-color filter layer SCL2 overlap each other.

It may also be considered that the blue sub-color filter layer SCL1 and the green sub-color filter layer SCL3 may overlap each other in the space between the transmission areas TA. However in such a scenario, since a wavelength band to which light transmitting through the blue sub-color filter layer SCL1 belongs and a wavelength band to which light transmitting through the green sub-color filter layer SCL3 belongs may overlap partially, effective light shielding may not be performed. It may also be considered that the red sub-color filter layer SCL2 and the green sub-color filter layer SCL3 may overlap each other in the space between the transmission areas TA. However in such a scenario, since a wavelength band to which light transmitting through the red sub-color filter layer SCL2 belongs and a wavelength band to which light transmitting through the green sub-color filter layer SCL3 belongs may overlap partially, effective light shielding may not be performed. In the display apparatus according to the embodiment, the blue sub-color filter layer SCL1 and the red sub-color filter layer SCL2 may overlap in the space between the transmission areas TA so that effective light shielding may be performed.

It may also be considered that the blue sub-color filter layer SCL1, the red sub-color filter layer SCL2, and the green sub-color filter layer SCL3 overlap one another in the space between the transmission areas TA as in the main display area MDA. However, if the blue sub-color filter layer SCL1, the red sub-color filter layer SCL2, and the green sub-color filter layer SCL3 overlap one another in the space between the transmission areas TA, the area of the space between the transmission areas TA may increase, and as such the area of each of the transmission areas TA may decrease or the area of the sub-display areas SDA may decrease. In the end, the component 40 may not be able to receive enough light and/or sound from the outside, or it may cause the resolution in the component area CA to be extremely low.

However, in the display apparatus according to the embodiment, only the blue sub-color filter layer SCL1 and the red sub-color filter layer SCL2 may overlap each other in the space between the transmission areas TA. This allows the component 40 to maintain the appropriate resolution in the component area CA, while creating an environment where the component 40 may work properly.

As shown in FIG. 11, in the area between the transmission areas TA, a width W1 of the blue sub-color filter layer SCL1 may be greater than a width W2 of the red sub-color filter layer SCL2. In each of the transmission areas TA, the area of each of the second sub-openings SOP2 of the red sub-color filter layer SCL2 may be greater than the area of each of the first sub-openings SOP1 of the blue sub-color filter layer SCL1.

As occasion demands, an overcoat layer including an organic material such as polyimide or the like may be located on the anti-reflection layer 500 including the color filter layers. The overcoat layer throughout the main display area MDA and the component area CA may be integral with each other as a single body. As described above, a cover window (not shown) throughout the main display area MDA and the component area CA may be integral with each other as a single body and may be disposed over the anti-reflection layer 500, and the cover window may be coupled to the anti-reflection layer 500 through an adhesive layer such as an optically clear adhesive (OCA).

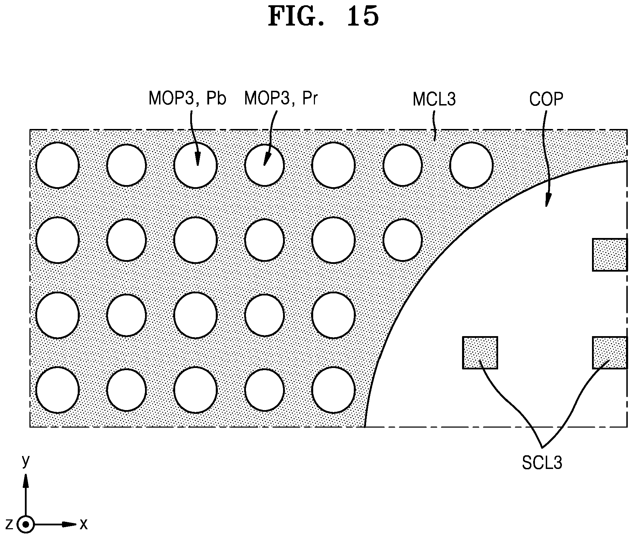

FIG. 15 is a plan view schematically illustrating a part of the display apparatus of FIG. 1, and shows a part of the main display area MDA and a part of the component area CA. The main display area MDA may surround the component area CA in a plan view. FIG. 15 shows the green main color filter layer MCL3 and the green sub-color filter layers SCL3. The green main color filter layer MCL3 may be disposed on the red main color filter layer MCL2 and fill the first main opening corresponding to the green sub-pixel Pg among the first main openings MOP1 of the blue main color filter layer MCL1 and the second main opening corresponding to the green sub-pixel Pg among the second main openings MOP2 of the red main color filter layer MCL2, respectively. Furthermore, the green main color filter layer MCL3 may have third main openings MOP3 for exposing the center of the main pixel electrode corresponding to the blue sub-pixel Pb and the center of the main pixel electrode corresponding to the red sub-pixel Pr as shown in FIG. 15. As described above, in case that the main display area MDA surrounds the component area CA in a plan view, the green main color filter layer MCL3 may have a component opening COP corresponding to the component area CA. When viewed from a direction (z-axis direction) perpendicular to the substrate 100 (i.e., when viewed in a plan view), multiple green sub-color filter layers SCL3 that may be spaced apart from one another may be located in the component opening COP. As described above, the position of the green sub-color filter layers SCL3 may correspond to the position of the green sub-pixels Pg in the component area CA.

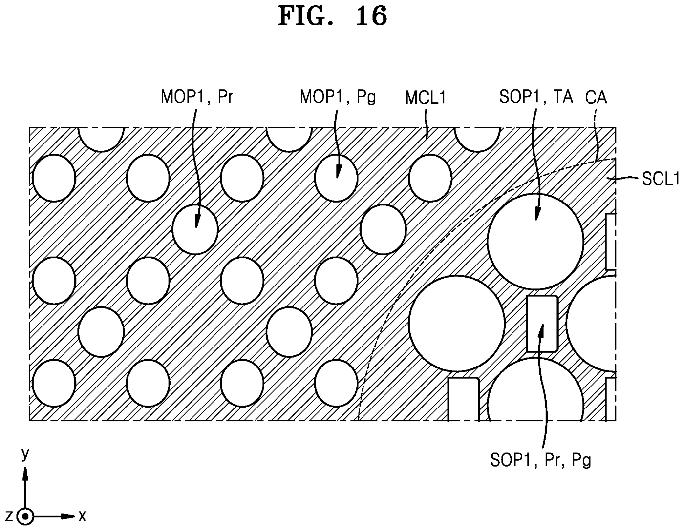

FIG. 16 is a plan view schematically illustrating a part of the display apparatus of FIG. 1, and shows a part of the main display area MDA and a part of the component area CA, as in FIG. 15. The main display area MDA may actually surround the component area CA in a plan view. FIG. 16 shows the blue main color filter layer MCL1 and the blue sub-color filter layers SCL1. The blue main color filter layer MCL1 may have first main openings MOP1 for exposing the center of the main pixel electrode corresponding to the red sub-pixel Pr and the center of the main pixel electrode corresponding to the green sub-pixel Pg as shown in FIG. 16. The blue sub-color filter layer SCL1 may have first sub-openings SOP1 for exposing the transmission areas TA and the center of the sub-pixel electrode in the component area CA corresponding to the red sub-pixel Pr and the center of the sub-pixel electrode in the component area CA corresponding to the green sub-pixel Pg. The blue main color filter layer MCL1 and the blue sub-color filter layers SCL1 may be integral with each other as a single body. Similarly, the red main color filter layer MCL2 and the red sub-color filter layers SCL2 may be integral with each other as a single body.

According to an embodiment of the disclosure described above, a display apparatus of which configuration may be simple and in which reflection of external light may be effectively reduced can be implemented. Of course, the scope of the disclosure may not be limited by these effects.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus comprising:
a substrate (100) comprising a component area (CA) and a main display area (MDA), the component area (TA) including sub-display areas (SDA) and transmission areas (TA), the main display area (CA) at least partially surrounding the component area;
main pixel electrodes (210) located in the main display area and spaced apart from one another;
sub-pixel electrodes located in the sub-display areas and spaced apart from one another;
three color filter layers (MCL1, MCL2, MCL3) stacked on one another in the main display area (MDA) to correspond to a space between each two of the main pixel electrodes that are adjacent to each other; and
two color filter layers (SCL1, SCL2) stacked on each other in the component area (CA) to correspond to a space between the transmission areas (TA).

2. The display apparatus (1) of claim 1, wherein the three color filter layers comprise:
a blue main color filter layer (MCL1) through which blue light passes;
a red main color filter layer (MCL2) through which red light passes; and
a green main color filter layer (MCL3) through which green light passes.

3. The display apparatus (1) of claim 2, wherein the blue main color filter layer (MCL1), the red main color filter layer (MCL2), and the green main color filter layer (MCL3) are sequentially stacked on one another in a direction away from the substrate (100).

4. The display apparatus (1) of claim 2 or 3, wherein
the main display area includes: a red sub-pixel (Pr), a green sub-pixel (Pg), and a blue sub-pixel (Pb),
each of the red sub-pixel, the green sub-pixel and the blue sub-pixel comprises one of the main pixel electrodes,
the blue main color filter layer (MCL1) has first main openings (MOP1) exposing a center of one of the main pixel electrodes corresponding to the red sub-pixel and a center of one of the main pixel electrodes corresponding to the green sub-pixel,
the red main color filter layer (MCL2) is disposed on the blue main color filter layer and fills one of the first main openings corresponding to the red sub-pixel,
the red main color filter layer (MCL2) has second main openings (MOP2) exposing a center of one of the main pixel electrodes corresponding to the blue sub-pixel and the center of the one of the main pixel electrodes corresponding to the green sub-pixel,
the green main color filter layer (MCL3) is disposed on the red main color filter layer and fills one of the first main openings (MOP1) corresponding to the green sub-pixel and one of the second main openings corresponding to the green sub-pixel, and
the green main color filter layer (MCL3) has third main openings (MOP3) exposing the center of the one of the main pixel electrodes corresponding to the blue sub-pixel and the center of the one of the main pixel electrodes corresponding to the red sub-pixel.

5. The display apparatus (1) of claim 4, wherein
an area of one of the third main openings (MOP3) corresponding to the red sub-pixel is greater than an area of the one of the first main openings (MOP1) corresponding to the red sub-pixel,
an area of one of the second main openings (MOP2) corresponding to the green sub-pixel is greater than an area of the one of the first main openings (MOP1) corresponding to the green sub-pixel, and
an area of one of the third main openings (MOP3) corresponding to the blue sub-pixel is greater than an area of one of the second main openings corresponding to the blue sub-pixel.

6. The display apparatus (1) of any of the preceding claims, wherein the two color filter layers (SCL1, SCL2) comprise:
a blue sub-color filter layer (SCL1) through which blue light passes; and
a red sub-color filter layer (SCL2) through which red light passes.

7. The display apparatus (1) of claim 6, wherein the blue sub-color filter layer (SCL1) and the red sub-color filter layer (SCL2) are sequentially stacked on each other in a direction away from the substrate (100).

8. The display apparatus (1) of claim 6 or 7, wherein
the component area (CA) includes: a red sub-pixel (Pr), a green sub-pixel (Pg), and a blue sub-pixel (Pb),
each of the red sub-pixel, the green sub-pixel and the blue sub-pixel comprises one of the sub-pixel electrodes,
the blue sub-color filter layer (SCL1) has first sub-openings (SOP1) exposing the transmission areas and a center of a one of the sub-pixel electrodes corresponding to the red sub-pixel and a center of one of the sub-pixel electrodes corresponding to the green sub-pixel, and
the red sub-color filter layer (SCL2) is disposed on the blue sub-color filter layer and fills one of the first sub-openings corresponding to the red sub-pixel, the red sub-color filter layer (SCL2) having second sub-openings (SOP2) exposing the transmission areas and a center of one of the sub-pixel electrodes corresponding to the blue sub-pixel and the center of the one of the sub-pixel electrodes corresponding to the green sub-pixel.

9. The display apparatus (1) of claim 8, wherein the component area (CA) further comprises, a green sub-color filter layer (SCL3) filling one of the first sub-openings (SOP1) corresponding to the green sub-pixel and one of the second sub-openings (SOP2) corresponding to the green sub-pixel, and/or, wherein the green sub-color filter layer (SCL3) extends to a space between the green sub-pixel and one of the transmission areas (TA) adjacent to the green sub-pixel.

10. The display apparatus (1) of claim 9, wherein a distal end of the green sub-color filter layer (SCL3) in a direction to the one of the transmission areas (TA) adjacent to the green sub-pixel is disposed on the red sub-color filter layer, and/or wherein the green sub-color filter layer (SCL3) is disposed on the red sub-color filter layer in the space between the green sub-pixel and the one of the transmission areas (TA) adjacent to the green sub-pixel.

11. The display apparatus (1) of claim 9 or 10, wherein the green sub-color filter layer (SCL3) is of an island shape in a plan view.

12. The display apparatus of any of claims 8 to 11, wherein a width of the blue sub-color filter layer (SCL1) is greater than a width of the red sub-color filter layer (SCL2) in an area between ones of the transmission areas, and/or wherein in the transmission areas (TA), an area of each of the second sub-openings is greater than an area of each of the first sub-openings.

13. The display apparatus (1) of any of claims 8 to 12, wherein in the main display area (MDA):
the three color filter layers comprise a blue main color filter layer (MCL1) through which blue light passes, a red main color filter layer (MCL2) through which red light passes, and a green main color filter layer (MCL3) through which green light passes,
a red sub-pixel, a green sub-pixel, and a blue sub-pixel are included,
each of the red sub-pixel, the green sub-pixel and the blue sub-pixel comprises one of the main pixel electrodes,
the blue main color filter layer (MCL1), the red main color filter layer (MCL2), and the green main color filter layer (MCL3) are sequentially stacked on each other in a direction away from the substrate (100),
the blue main color filter layer (MCL1) has first main openings exposing a center of one of the main pixel electrodes corresponding to the red sub-pixel and a center of one of the main pixel electrodes corresponding to the green sub-pixel,
the red main color filter layer (MCL2) is disposed on the blue main color filter layer and fills one of the first main openings corresponding to the red sub-pixel,
the red main color filter layer (MCL2) has second main openings exposing a center of one of the main pixel electrodes corresponding to the blue sub-pixel and the center of the one of the main pixel electrodes corresponding to the green sub-pixel,
the green main color filter layer (MCL3) is disposed on the red main color filter layer and fills one of the first main openings corresponding to the green sub-pixel and one of the second main openings corresponding to the green sub-pixel, and
the green main color filter layer (MCL3) has third main openings exposing the center of the one of the main pixel electrodes corresponding to the blue sub-pixel and the center of the one of the main pixel electrodes corresponding to the red sub-pixel.

14. The display apparatus (1) of claim 13, wherein
the blue main color filter layer (MCL1) and the blue sub-color filter layer (SCL1) are integral with each other as a single body, and
the red main color filter layer (MCL2) and the red sub-color filter layer (SCL2) are integral with each other as a single body, and/or, wherein the main display area (MDA) surrounds the component area (CA).

15. The display apparatus (1) of claim 13 or 14, wherein the green main color filter layer (MCL3) has a component opening corresponding to the component area, and/or, further comprising a plurality of green sub-color filter layers (SCL3) that are located in the component opening and spaced apart from one another in a plan view.
